(19) Europäisches Patentamt / European Patent Office / Office européen des brevets

(11) **EP 4 632 402 A1**

(12) **EUROPEAN PATENT APPLICATION**

(43) Date of publication:
**15.10.2025 Bulletin 2025/42**

(21) Application number: **25169720.7**

(22) Date of filing: **10.04.2025**

(51) International Patent Classification (IPC):
**G01R 31/3832** $^{(2019.01)}$

(52) Cooperative Patent Classification (CPC):
**G01R 31/3833;** G01R 31/367

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.04.2024 PCT/CN2024/087071**
**09.04.2025 US 202519174081**

(71) Applicant: **Analog Devices International Unlimited Company Limerick (IE)**

(72) Inventors:
• **SHI, Hongfei**
  Co. Limerick (IE)
• **GU, Xiaoyun**
  Co. Limerick (IE)
• **LIN, Yijing**
  Co. Limerick (IE)
• **WANG, Yong**
  Co. Limerick (IE)
• **LIAO, Dong**
  Co. Limerick (IE)
• **YANG, Ling**
  Co. Limerick (IE)

• **LUO, Rengui**
  Co. Limerick (IE)
• **LI, Dong**
  Co. Limerick (IE)
• **GAO, Chenhui**
  Co. Limerick (IE)
• **ZHANG, Ming**
  Co. Limerick (IE)
• **BAI, Yiwei**
  Co. Limerick (IE)
• **ZHAO, Ziwei**
  Co. Limerick (IE)
• **WANG, Tongxi**
  Co. Limerick (IE)
• **JIN, Yinji**
  Co. Limerick (IE)
• **LI, Dengrong**
  Co. Limerick (IE)
• **MAI, Zihao**
  Co. Limerick (IE)
• **YU, Meng**
  Co. Limerick (IE)

(74) Representative: **Yang, Shu**
  **Withers & Rogers LLP**
  **2 London Bridge**
  **London SE1 9RA (GB)**

(54) **BATTERY MANAGEMENT SYSTEM FOR DETERMINING CHARGE TRANSFER**

(57) A battery management system can include a host microcontroller, which can be operated in accordance with a first clock signal, and an analog front end (AFE) circuit, where the AFE circuit can be operated in accordance with a second clock signal that can be unsynchronized with the first clock signal. The AFE circuit can include an input which can be configured to receive a representation of a battery current associated with one or more cells in a battery system. The AFE circuit can also include current measurement circuitry, included in or coupled to the AFE circuit, which can be configured to generate an average current value representative of an average of the battery current for a specified time period. The host microcontroller can be configured to determine a time value representative of a duration of the specified time period, and determine, based on the indication of the average current value, a current transfer value of the battery current during the specified time period.

EP 4 632 402 A1

**Description**

CLAIM OF PRIORITY

This patent application claims the benefit of priority of Shi et al., Patent Cooperation Treaty Application Serial Number PCT/CN2024/087071 entitled "COULOMB COUNTER FOR VEHICLE BATTERY MANAGEMENT SYSTEM," filed on April 10, 2024, and to US non-provisional application US19/174,081 entitled "BATTERY MANAGEMENT SYSTEM FOR DETERMINING CHARGE TRANSFER," filed on April 9, 2025, which are hereby incorporated by reference herein in their entirety.

TECHNICAL FIELD

The present disclosure relates to electronics, and more particularly, but not by way of limitation, to a coulomb counter that can determine charge transfer from a battery or other electrochemical energy storage system.

BACKGROUND

Modern systems can use coulomb counters to determine an amount of charge transfer from an energy storage system, such as a battery. Examples of such systems include industrial electronics, electric passenger cars, electric industrial trucks, and energy storage systems. The determination of charge transfer may help in determining one or more of a system power output, a remaining system power capacity, or a state of charge (SoC) or state of health (SoH) of an energy storage system.

SUMMARY

In an example, a battery management system can include a host microcontroller, which can be operated in accordance with a first clock signal, and an analog front end (AFE) circuit, where the AFE circuit can be operated in accordance with a second clock signal that can be unsynchronized with the first clock signal. The AFE circuit can include an input which can be configured to receive a representation of a battery current associated with one or more cells in a battery system. The AFE circuit can also include current measurement circuitry, included in or coupled to the AFE circuit, which can be configured to generate an average current value representative of an average of the battery current for a specified time period. The AFE circuit can also include communication circuitry, which can be configured to transmit an indication of the average current value to the host microcontroller. The host microcontroller can be configured to determine a time value representative of a duration of the specified time period, and determine, based on the indication of the average current value, a current transfer value of the battery current during the specified time period.

In an example, a method of operating a battery management system can include receiving an input representation of a battery current associated with one or more cells in a battery system, determining an indication of an average current value which can be representative of an average of the battery current for a specified time period, determining a time value which can be representative of a duration of the specified time period, and determining, based on the indication of the average current value, a current transfer value of the battery current during the specified time period.

In an example, a battery management system can include a host microcontroller, which can be operated in accordance with a first clock signal, and an analog front end (AFE) circuit, where the AFE circuit can be operated in accordance with a second clock signal that can be unsynchronized with the first clock signal. The AFE circuit can include an input which can be configured to receive a representation of a battery current associated with one or more cells in a battery system. The AFE circuit can also include current measurement circuitry, included in or coupled to the AFE circuit, the current measurement circuitry can be configured to generate an average current value representative of an average of the battery current for a specified time period. The AFE circuit can also include a second input which can be configured to receive a second representation of the battery current. The AFE circuit can also include second current measurement circuitry, included in or coupled to the AFE circuit, the second current measurement circuitry can be configured to generate a second average current value representative of an average of the battery current for the specified time period. The AFE circuit can also include communication circuitry, which can be configured to transmit an indication of one or more of (1) the average current value, (2) the second average current value, or (3) a determined composite of the average current value and the second average current value, to the host microcontroller. The host microcontroller can be configured to determine a time value representative of a duration of the specified time period, and determine, based on the received indication, a current transfer value of the battery current during the specified time period.

BRIEF DESCRIPTION OF THE DRAWINGS

In the drawings, which may not be drawn to scale, like numerals may describe substantially similar components throughout one or more of the views. Like numerals having different letter suffixes may represent different instances of substantially similar components. The drawings illustrate generally, by way of example but not by way of limitation.

FIG. 1 shows a block diagram of an example of portions of an electrical system.
FIG. 2 shows a diagram of an example of portions of a battery management system.
FIG. 3 shows a diagram of an example of portions of an AFE circuit.
FIG. 4A shows a graph in time illustrating an example of operating portions of an AFE circuit.
FIG. 4B shows a graph in time illustrating an example of operating portions of an AFE circuit.
FIG. 5 shows a graph in time illustrating an example of operating portions of an AFE circuit.
FIG. 6 shows a graph in time illustrating an example of operating portions of an AFE circuit.
FIG. 7 shows a graph in time illustrating an example of operating portions of an AFE circuit.
FIG. 8 shows a block diagram of an example of portions of an AFE circuit and the operation thereof.
FIG. 9 shows an example of portions of a method for operating a battery management system.
FIG. 10 is a block diagram of an example of portions of a machine upon which one or more portions of the present disclosure may be implemented.

DETAILED DESCRIPTION

A coulomb counter may operate by integrating a measured current value over time to determine a measurement of charge transfer. The measured current value may be updated at recurring intervals, such as corresponding to the sampling frequency of an analog-to-digital converter (ADC). The integration of these discrete current measurements may be a discrete integration, which may be performed by multiplying a discrete current measurement by a length of time between current measurements. The accuracy of the charge transfer measurement may depend upon one or more of the frequency of the current measurement, the accuracy of the current measurement, the accuracy of the time measurement, and the proper handling of the current and time measurement data.

The present inventors have recognized, among other things, that the frequency of the current measurement may be increased by using an analog front end (AFE) circuit that can sample recurrently, record results, and report recorded results back to a host microcontroller. The AFE may be able to sample more quickly than the host microcontroller. This can be due to the AFE having fewer parallel tasks or overhead tasks than the host microcontroller, or the AFE being located more closely to the charge transfer to be measured. The AFE may have a lower power consumption than the host microcontroller, which may reduce a power consumed by the system in determining charge transfer.

The present inventors have recognized, among other things, that it can be desirable to determine charge transfer according to a specified functional safety standard. Accordingly, it may be desirable for the AFE circuit to determine an average current value according to the specified functional safety standard and for the host microcontroller to determine a time value according to a specified functional safety standard. Multiplying the average current value by the time value may generate a current transfer value that is determined according to the specified functional safety standard. In an example, the AFE circuit need not be able to determine a time value according to the specified functional safety standard.

The present inventors have recognized, among other things, that clock signal used by the AFE circuit can drift, and it can be desirable to accommodate for this drift. Accordingly, it can be desirable to determine an amount of clock drift, determine an estimated high-end inaccuracy in the current transfer value caused by the clock drift, or both.

The AFE may also attempt to increase the accuracy of current measurements, such as by using a programmable gain amplifier (PGA) to amplify the analog current signal before conversion to a digital measured current value. The PGA may be connected to an automatic gain control (AGC) circuit that attempts to keep the analog signal provided to the ADC above a low threshold, such as to increase the usable resolution of the ADC. The AGC may attempt to keep the ADC from receiving an analog signal higher than a maximum input of the ADC, such as to prevent the loss of data due to clipping or saturation of the ADC. The AGC may be located on the AFE circuit, such as to allow for a shorter response time between the signal provided to the ADC being outside a desired range and the adjustment of the PGA using the AGC.

The present inventors have recognized, among other things, that the AFE circuit may have a less expensive or less accurate clock than the host microcontroller, which may make it desirable to offload at least a portion of the timing to the host microcontroller, such as may include offloading a portion of the timing used in charge transfer calculations. The host microcontroller may have a more accurate clock, such as a precision crystal oscillator. There need not be a shared clock signal between the AFE and the host microcontroller, such as due to a voltage level difference between the AFE and the host microcontroller. A voltage level difference may introduce a need for the use of one or more of a DC-isolated bus or level switching circuits for data and clock connections between the AFE and host microcontroller. DC-isolated buses may have restricted bandwidth, and level switching circuits may be one or more of expensive, power-hungry, or bulky. For these and other reasons, it may be desirable to use a message-based timing system to offload a portion of the timing from the AFE to the host microcontroller.

The present inventors have recognized, among other things, that the communication connection, such as a DC-isolated bus, between the AFE and the host microcontroller may be one or more of low bandwidth, crowded with a number of communication messages, or unstable. Therefore, it may be desirable to make message-based communications between the AFE and host microcontroller more robust, such as by monitoring for failed messages and resending failed messages. This document describes, among other things, systems and methods of charge transfer measurement using an AFE circuit and a host microcontroller.

Charge transfer through a system, such as an energy storage system, can be calculated by integrating the current flowing through the system with respect to time according to the following equation:

$$Q = \int I\, dt$$

where $Q$ is the charge transfer and $I$ is the current. $I$ may be constant or may have different values at different times. In a discrete system, such as a digital system, discrete integration may be used to determine charge transfer according to the following equation:

$$Q = \sum I\, \Delta T$$

Discrete integration may only provide an approximation of charge transfer, such as due to one or more of $I$ varying over time, inaccurate measurements of $I$, or inaccurate measurements of $\Delta T$. A more rapid change in $I$ over time may result in a less accurate measurement of charge transfer. A smaller time increment, $\Delta T$, may result in a more accurate measurement of charge transfer. More accurate measurements of $I$ and $\Delta T$ may result in a more accurate measurement of charge transfer. Charge transfer may be measured in a unit such as the coulomb, which is equal to the amount of charge transferred in one second by one ampere of current.

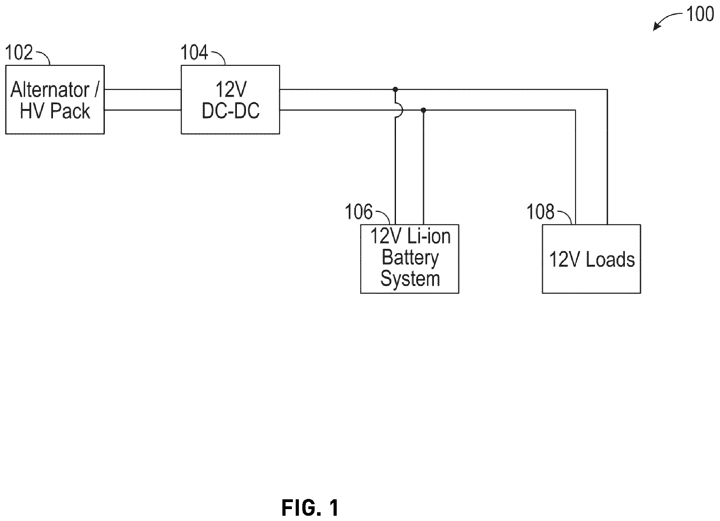

FIG. 1 shows a block diagram of an example of portions of an electrical system 100. FIG. 1 shows that the electrical system 100 can include an electrical power source 102, a DC-to-DC converter 104, an energy storage device 106, and an electrical load 108. The electrical system 100 can be used in any system, such as can include a vehicle system (e.g., a liquid fuel vehicle system, a hybrid vehicle system, an electric vehicle system). In an example, the electrical system 100 can be configured differently, such as can include adding, removing, or rearranging components.

The electrical power source 102 can provide at least a portion of the input power to the electrical system 100. The electrical power source 102 can include one or more of an alternator (e.g., use to generate electrical power from input mechanical power, such as from a combustion engine), a battery pack (e.g., a "high-voltage" electric vehicle battery pack, such as can provide the main power source for the locomotion of the vehicle), or another power source (e.g., a fuel cell). The electrical power source 102 can provide power continuously or substantially continuously, or may provide power during more limited times, such as can include when the vehicle is powered on (e.g., an internal combustion engine is running). In an example, a "high-voltage" battery pack may be capable of providing power continuously (e.g., the battery pack is not turned off or on), but the battery pack may be disconnected for one or more reasons, such as can include one or more of safety, power saving (e.g., disabling one or more systems, such as the DC-to-DC converter 104).

The direct current (DC)-to-DC converter 104 can be configured to convert a DC voltage or a substantially DC voltage of the electrical power source 102 to a different DC voltage or substantially DC voltage (e.g., a higher or lower voltage). For example, the DC-to-DC converter 104 can convert a voltage from a "high-voltage" battery pack (e.g., 100 to 1500 volts) to a lower voltage for use by a car's electronics and non-locomotion systems (e.g., lights, sensors, safety systems, etc.), such as can operate at 12 volts. In an example, the DC-to-DC converter 104 can be or include a dedicated battery charger, such as can be configured for charging a specific type of battery (e.g., lead-acid, lithium (e.g., a lithium-ion battery), etc.).

The energy storage device 106 can include a battery (e.g., a battery system), such as can include a lead-acid battery, a lithium battery, or another system capable of storing electrical energy. The energy storage device 106 can provide power to an electrical load 108, such as when the electrical power source 102 is not providing power to the electrical load 108. In an example, the energy storage device 106 can have a nominal voltage, such as can include 12 volts or approximately 12 volts. In an example, the energy storage device 106 can also provide the energy to start a vehicle (e.g., start a combustion engine using an electric starter).

The electrical load 108 can include one or more electrical loads, such as can be configured to use electrical power to perform one or more functions (e.g., a vehicle control unit (VCU), an engine control unit (ECU), lighting (e.g., illumination lighting of the interior of vehicle or road surface, position lighting, signal lighting) power steering, audio, infotainment, navigation, etc.) The electrical load 108 can be configured to operate across a voltage range that corresponds or overlaps with a voltage range of the energy storage device 106 and/or an output of the DC-to-DC converter 104.

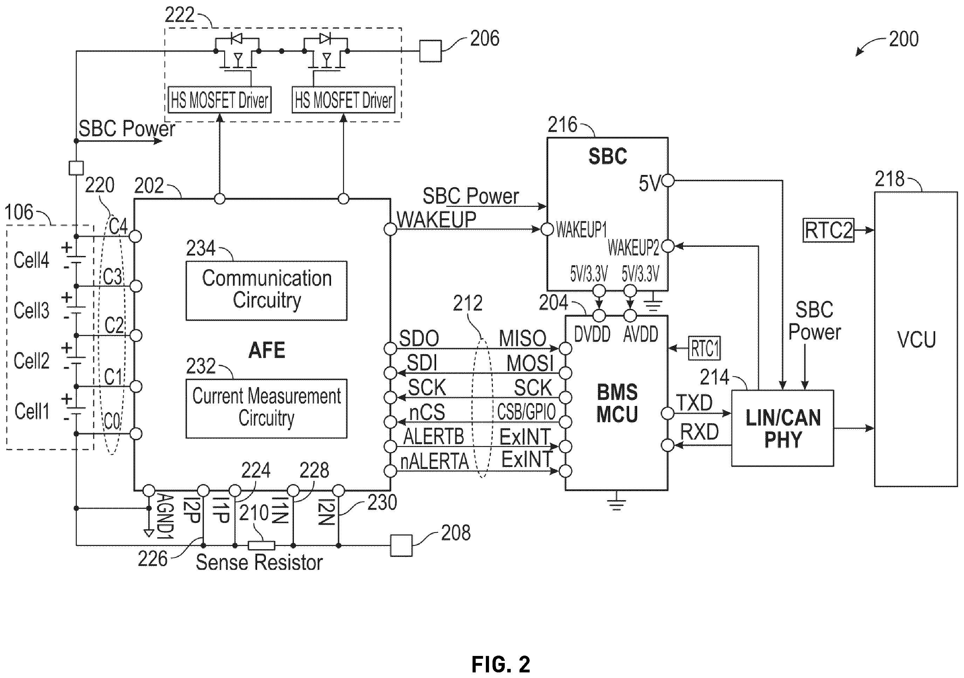

FIG. 2 shows a diagram of an example of portions of a battery management system 200. FIG. 2 shows that the battery management system 200 can include an analog front end (AFE) circuit 202, a host microcontroller 204, voltage regulation circuitry 216, and a vehicle control unit 218.

The host microcontroller 204 can include any circuit capable of executing instructions (e.g., a processor, a memory, etc.) The host microcontroller 204 can be configured to perform one or more operations in the battery management system 200, which can include monitoring one or more properties of the energy storage device 106 (e.g., state of charge (SoC), state of health (SoH), etc.). The host microcontroller 204 can be operated in accordance with a first clock signal. For example, the host microcontroller 204 can include a clock generation circuit and/or include circuitry to receive a clock signal from an external clock generation circuit.

The host microcontroller 204 can be coupled to one or more of the AFE circuit 202, the voltage regulation circuitry 216, or the vehicle control unit 218 (e.g., through interface circuitry 214). The voltage regulation circuitry 216 can provide power to the host microcontroller 204. The voltage regulation circuitry 216 can receive power from the energy storage device 106 or another source and provide power to the host microcontroller 204, which can include adjusting a voltage or current level of the power received by the voltage regulation circuitry 216 before providing the power to the host microcontroller 204.

The AFE circuit 202, can be configured to perform one or more operations in the battery management system 200. The AFE circuit 202 can be coupled to the energy storage device 106, such as through one or more voltage nodes 220. For example, the voltage nodes 220 can be coupled to the energy storage device 106 at one or more locations (e.g., a positive terminal, a negative terminal, between one or more cells and/or groups of cells, etc.). The voltage nodes 220 can provide an indication of a voltage of one or more portions of the energy storage device 106. In an example, the voltage nodes 220 can provide power to the AFE circuit 202 and/or one or more portions of the battery management system 200.

In the example of FIG. 2, the energy storage device 106 can include a battery system. The AFE circuit 202 can include an input configured to receive a representation of a battery current associated with one or more cells in a battery system (e.g., the energy storage device 106). This input can include one or more current nodes, which can be configured to receive an indication of a current through one or more portions of the energy storage device 106. In an example, the current nodes can be configured to measure a voltage across a sense resistor 210 arranged in series with the energy storage device 106 (e.g., the current through the sense resistor 210 can match the current through the energy storage device 106). The voltage across the sense resistor 210 can be used in conjunction with a specified, measured, or calibrated resistance of the sense resistor 210 to determine a current through the sense resistor 210. There can be a first positive current node 224, a first negative current note 228, a second positive current node 226, and a second negative current node 230. The current measurement performed by the AFE circuit 202 can be at least partially redundant.

The AFE circuit 202 can also be configured to control the isolation circuitry 222. The isolation circuitry 222 can be configured to isolate the energy storage device 106 from one or more other circuits, which can be coupled between the positive terminal 206 and the negative terminal 208. For example, the isolation circuitry 222 can be configured to disconnect the energy storage device 106 from one or more portions of a vehicle system, such as to one or more of conserve power or remove power from one or more systems for safety reasons.

The AFE circuit 202 can be operated in accordance with a second clock signal. For example, the AFE circuit 202 can include a clock generation circuit and/or include circuitry to receive a clock signal from an external clock generation circuit. In an example, the second clock signal need not be synchronized with the first clock signal. For example, the first clock signal and the second clock signal can be generated by separate clock generation circuits. In an example, the host microcontroller 204 need not send an indication of the clock frequency and/or phase of the first clock signal to the AFE circuit 202. In an example, the AFE circuit 202 need not send an indication of the clock frequency and/or phase of the second clock signal to the host microcontroller 204.

The AFE circuit 202 can include or be coupled to current measurement circuitry 232. The current measurement circuitry 232 can be configured to generate an average current value, which can be representative of an average of the battery current for a specified time period. For example, the current measurement circuitry 232 can recurrently (e.g., periodically) determine the battery current through the energy storage device 106 and use information about the length of time between current measurements to determine an average current value. In an example, the current measurement circuitry 232 can measure the battery current periodically, sum the measured currents, and divide the summed currents by the number of measurements to determine the average current value (e.g., an average current in amperes), such as according to equation 1.

$$Average\ Current = \frac{Accumulated\ Current}{Number\ of\ Samples} \qquad\qquad Equation\ 1$$

The AFE circuit 202 can include communication circuitry 234. The communication circuitry 234 can be configured to transmit an indication of the average current value to the host microcontroller 204. For example, at some point after the specified time period, the AFE circuit 202 can transmit an indication of the average current value to the host microcontroller 204.

The host microcontroller 204 can be configured to determine a time value (e.g., a time value in seconds) representative of a duration of the specified time period. The host microcontroller 204 can be configured to determine, such as based on the indication of the average current value received from the AFE circuit 202, a current transfer value of the battery current during the specified time period. The host microcontroller 204 can be configured to determine the current transfer value at least in part by multiplying a representation of the time value by a representation of the indication of the average current value. The host microcontroller 204 can multiply the average current value by the time value to determine a current transfer value (e.g., a charge transfer, such as in coulombs), such as according to equations 2 & 3.

$$Charge\ Transfer = Average\ Current * Time \qquad \text{Equation 2}$$

$$Charge\ Transfer = \frac{Accumulated\ Current}{Number\ of\ Samples} * Time \qquad \text{Equation 3}$$

The AFE circuit 202 can determine the average current value in correspondence to a specified functional safety standard. For example, the specified functional safety standard can include or define a set of specifications and/or standards for a specific application (e.g., a specified functional safety standard applying to consumer automobiles). For example, the specified functional safety standard may include one or more of a specified precision (e.g., precision of the current measurement circuitry 232, precision of a clock circuit, etc.), a specified reliability (e.g., mean time to failure of the AFE circuit 202) a specified level of redundancy (e.g., redundant current measurement circuitry 232), or a specified combination thereof. This can help to ensure that the average current value meets a level of accuracy or reliability associated with the specified functional safety standard.

The host microcontroller 204 can determine the time value in correspondence to the specified functional safety standard. For example, the specified functional safety standard may include one or more of a specified precision (e.g., precision of the clock circuitry used by the host microcontroller 204), a specified level of reliability, a specified level of redundancy, or a specified combination thereof. This can help to ensure that the time value meets a level of accuracy or reliability associated with the specified functional safety standard. In an example, the host microcontroller 204 can determine the time value according to a different functional safety standard.

The host microcontroller 204 can determine the current transfer value in correspondence to the specified functional safety standard. For example, the specified functional safety standard may include one or more of a specified precision (e.g., precision of the processor circuitry used by the host microcontroller 204), a specified level of reliability, a specified level of redundancy, or a specified combination thereof. This can help to ensure that the current transfer value meets a level of accuracy or reliability associated with the specified functional safety standard. In an example, the host microcontroller 204 can determine the current transfer value according to a different functional safety standard.

In an example, the AFE circuit 202 can be configured to operate in accordance with the second clock signal which can be unsynchronized with the first clock signal. In this example, the second clock signal need not meet a specified functional safety standard for time determination included in the specified functional safety standard. For example, the clock circuit used by the AFE circuit 202 need not be accurate and/or precise enough to be used in determining a time value according to the specified functional safety standard. However, because the time value can be determined by the host microcontroller 204, the AFE circuit 202 need not determine a time value. The clock circuit used by the AFE circuit 202 can allow the AFE circuit 202 to determine the average current value according to the specified functional safety standard.

The first clock signal used by the host microcontroller 204 can be generated using a clock circuit that has one or more of a higher power consumption or a larger circuit area as compared to a clock circuit that generates the second clock signal used by the AFE circuit 202. For example, the clock circuit used by the host microcontroller 204 may be more precise than the clock circuit used by the AFE circuit 202, and this additional precision can be attained at least in part through increased power consumption or increased circuit area. The clock circuit of the host microcontroller 204 can be used for other functions, which can include one or more of providing a time to a host, data logging and/or event management (e.g., which can use timestamping and time sensitivity), or periodic wakeups, etc.

Determining the time value in correspondence to the specified functional safety standard can include cross checking time values from two or more of the following: an oscillator internal to the host microcontroller 204, a redundant oscillator internal to the host microcontroller 204, an oscillator external to the host microcontroller 204, or an oscillator included in another circuit. For example, the specified functional safety standard can specify that redundant time values (e.g., redundant clock signals, redundant time measurements) be cross-checked, such as to verify an accuracy of the determined time values to a specified level of accuracy or certainty.

In an example, the host microcontroller 204 can be recurrently put into a reduced power, sleep, or idle state. During this idle state, the host microcontroller 204 may perform reduced functions, which can include measuring the time value. The host microcontroller 204 need not perform calculations during the idle state. The host microcontroller 204 may come out of the idle state recurrently to determine the current transfer value, one or more battery properties (e.g., SoC), or both.

The AFE circuit 202 can be configured to receive the representation of the battery current recurrently at a specified frequency. The frequency can be configurable, such as by a user. Sampling at a greater frequency may provide a higher level of accuracy, result in a larger power consumption, or both. In an example, the specified sampling frequency can be reduced during times of one or more of low power draw (e.g., when the vehicle is off) or consistent power draw (e.g., when the vehicle is expected to have a consistent power draw, such as when powered off).

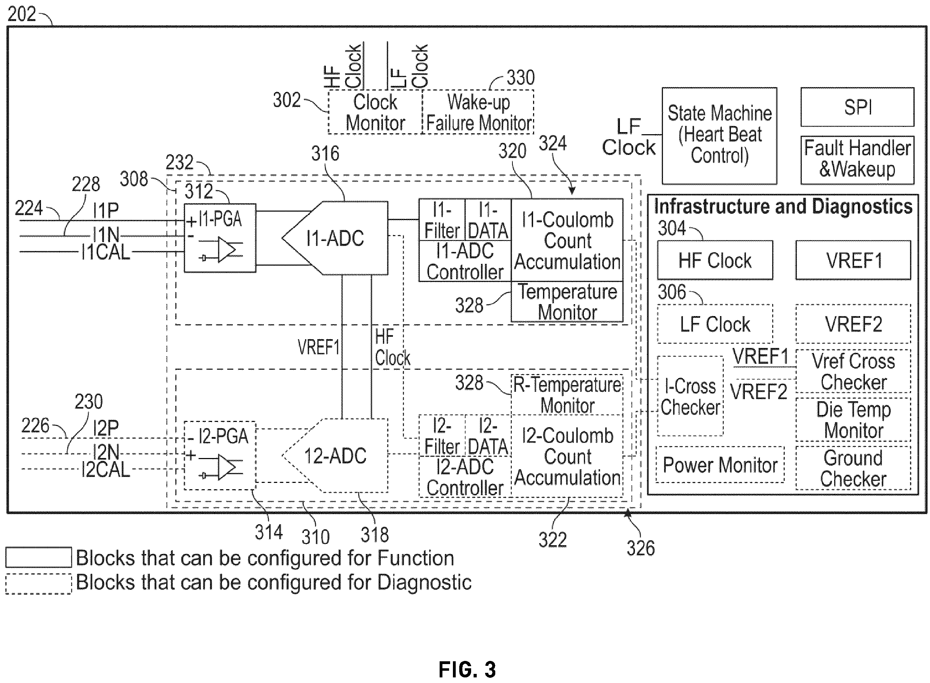

FIG. 3 shows a diagram of an example of portions of an AFE circuit 202. FIG. 3 shows that the AFE circuit 202 can include a high frequency clock generation circuit 304, a low frequency clock generation circuit 306, a first current measurement circuit 308, a second current measurement circuit 310, and clock drift monitoring circuitry 302.

One or more of the first current measurement circuit 308 or the second current measurement circuit 310 can be included in the current measurement circuitry 232. The first current measurement circuit 308 and the second current measurement circuit 310 can be redundant current measurement circuits (e.g., redundant current counters). The first current measurement circuit 308 and the second current measurement circuit 310 can include respective current inputs and respective accumulation counters (e.g., first current counter 324 and the second current counter 326). In an example, the first current measurement circuit 308 and the second current measurement circuit 310 can be configured similarly. In an example, the first current measurement circuit 308 and the second current measurement circuit 310 can differ in one or more ways.

The first current measurement circuit 308 can include a first pre-gain amplifier 312, a first ADC 316, and the first current value register 320. The first pre-gain amplifier 312 can be configured to receive a signal on the first positive current node 224 and the first negative current note 228, such as can be indicative of a voltage across the sense resistor 210. The first pre-gain amplifier 312 can be configured to adjust (e.g., amplify, attenuate) an amplitude of the received signal. The first pre-gain amplifier 312 can pass the adjusted signal to the first ADC 316.

The first ADC 316 can convert the signal received from the first pre-gain amplifier 312 (e.g., an analog voltage or current signal) into a digital signal representative of the received analog signal. The first ADC 316 can pass the digital representation to the first current counter 324. The first current counter 324 can determine the average current value during the specified time period, and store this value in the first current value register 320.

The second current measurement circuit 310 can include a second pre-gain amplifier 314, a second ADC 318, a second current counter 326, and a second current value register 322. The components of the second current measurement circuit 310 can function similarly to the components of the first current measurement circuit 308 discussed above.

The AFE circuit 202 can include a third clock signal, such as can be input on a third clock signal input (e.g., input from an internal or external clock generator). The third clock signal can operate at a different frequency than the second clock signal (e.g., a higher or lower frequency). One of the high frequency clock generation circuit 304 and the low frequency clock generation circuit 306 can generate the second clock signal and the other one of the high frequency clock generation circuit 304 and the low frequency clock generation circuit 306 can generate the third clock signal.

The clock drift monitoring circuitry 302 can be configured to compare (1) a measured number of cycles of a higher frequency one of the second clock signal and the third clock signal during a specified number of cycles of a lower frequency one of the second clock signal and the third clock signal to (2) a reference number of cycles. For example, the clock drift monitoring circuitry 302 can measure a number of cycles of the higher frequency clock signal during a specified number of cycles (e.g., one half a cycle, one cycle, two cycles, etc.) of the lower frequency clock signal. This can provide an indication of the relative frequency of the higher and lower frequency clock signals (e.g., how many times faster the higher frequency clock is than the lower frequency clock). By comparing the measured number of cycles to the reference number of cycles, it can be determined if the high frequency clock generation circuit 304 and/or low frequency clock generation circuit 306 are one or more of operating consistently (e.g., the relative frequency is not changing over time) or as expected (e.g., the relative frequency matches a specified relative frequency, such as a calibration frequency).

The clock drift monitoring circuitry 302 can be configured to determine the reference number of cycles. Determining the reference number of cycles can include measuring a number of cycles of a higher frequency one of the second clock signal and the third clock signal during a specified number of cycles of a lower frequency one of the second clock signal and the third clock signal at a beginning of the specified time period. This can determine a relative frequency of the clock signals at the start of the specified time period. The clock drift monitoring circuitry 302 can be configured to determine the measured number of cycles, such as following determining the reference number of cycles. The clock drift monitoring circuitry 302 can be configured to compare the reference number of cycles to the measured number of cycles. Determining the measured number of cycles and/or comparing the reference number of cycles to the measured number of cycles can be done recurrently (e.g., periodically).

If the measured number of cycles differs from the reference number of cycles by more than a specified amount (e.g., a number of cycles, a percentage), clock drift can be determined. By recurrently measuring the measured number of cycles, it can be determined if clock drift is occurring or has occurred at any point throughout the specified time period.

The AFE circuit 202 can also include temperature monitoring circuitry 328. The temperature monitoring circuitry 328 can be configured to determine a representation of a temperature of one or more portions of the AFE circuit 202 (e.g., the temperature of the AFE circuit 202). The temperature monitoring circuitry 328 can adjust one or more portions of the AFE circuit 202 (e.g., the first current value register 320, the clock drift monitoring circuitry 302), such as based on the measured temperature. The temperature monitoring circuitry 328 can report this temperature to the clock drift monitoring circuitry 302. In an example, when the measured clock drift and the clock drift predicted by the temperature monitoring circuitry 328 correlate to a specified degree, the clock drift can be corrected for, such as alternatively or in addition to triggering a clock drift event. In an example, the temperature monitoring circuitry 328 can generate an alarm when one or more of the temperature passes outside a specified bound (e.g., below a minimum, above a maximum), or the temperature changes at greater than a specified rate. The temperature monitoring circuitry 328 can be configured to trigger an alarm when temperature values are likely to cause clock drift.

The AFE circuit 202 can also include a wake-up failure monitor circuitry 330. The wake-up failure monitor circuitry 330 can be configured to monitor the wake-up event, host microcontroller 204, such as when the host microcontroller 204 is in a reduced power, sleep, or idle state. The AFE circuit 202 can wake up the host microcontroller 204 when an error occurs on the AFE circuit 202, such as a clock drift event, or a temperature alarm (e.g., triggered by the temperature monitoring circuitry 328). The wake-up failure monitor circuitry 330 can monitor the wake-up process and generate a fault or alarm if the host microcontroller 204 does not wake up within a specified amount of time.

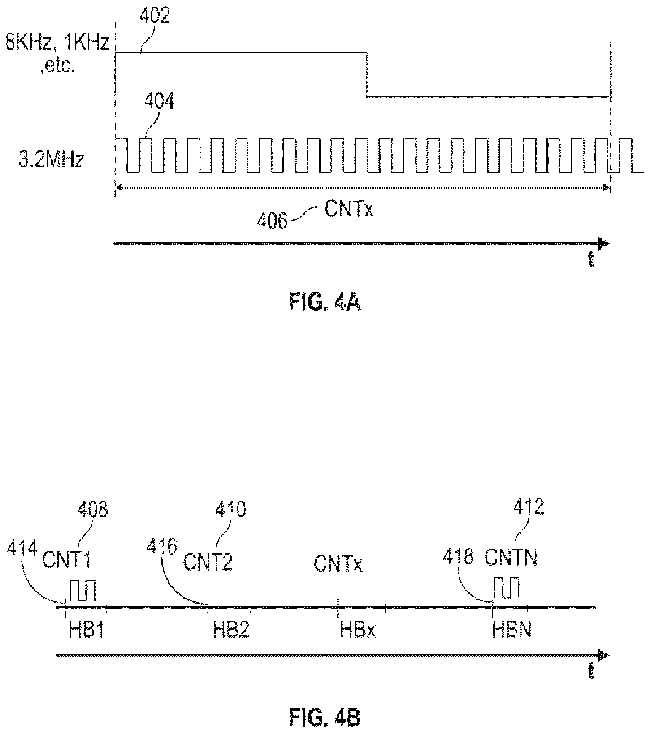

FIG. 4A shows a graph in time illustrating an example of operating portions of an AFE circuit 202. FIG. 4A shows a graph of the lower frequency clock signal 402, the higher frequency clock signal 404, and the measured number of cycles 406. In the example of FIG. 4A, the lower frequency clock signal 402 can include a 1 kilohertz clock or an 8 kilohertz clock. However, these are just examples and are not restrictive. In the example of FIG. 4A, the higher frequency clock signal 404 can include a 3.2 megahertz clock. However, this is just an example and is not restrictive. In the example of FIG. 4A, the number of cycles of the higher frequency clock signal 404 is counted during one cycle of the lower frequency clock signal 402.

FIG. 4B shows a graph in time illustrating an example of operating portions of an AFE circuit. FIG. 4B shows that the measured number of cycles may be determined at a first time 414, a second time 416, and an "nth" time 418. These measurements can result in a first measured number of cycles 408, a second measured number of cycles 410, and a "nth" measured number of cycles 412. In an example, the first measured number of cycles 408 (or the measured number of cycles corresponding to the start of the specified time period) can comprise the reference number of cycles. The clock drift monitoring circuitry 302 can be configured such that, in response to the measured number of cycles (e.g., any of the first measured number of cycles 408 through the "nth" measured number of cycles 412) differing (e.g., differing in a positive or negative direction, an absolute value of the difference) from the reference number of cycles by an amount greater than or equal to a threshold value, a clock drift is determined. 12.

In response to determining clock drift, an estimated indication of a high-end inaccuracy (e.g., a worst-case-scenario inaccuracy, a maximum estimated inaccuracy) on the average current value can determined by the AFE circuit 202, transmitted to the host microcontroller 204, or both.

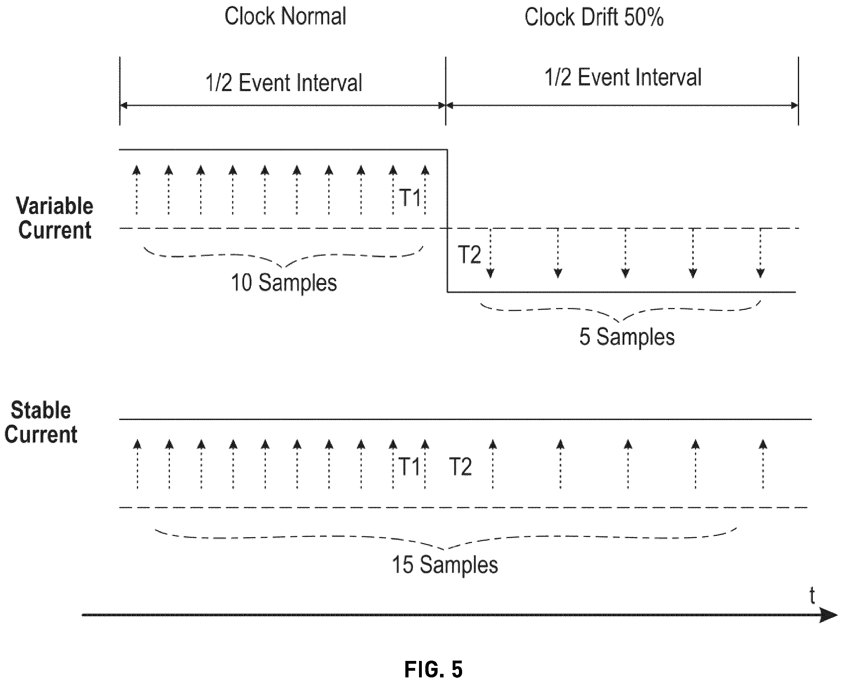

FIG. 5 shows a graph in time illustrating an example of operating portions of an AFE circuit 202. FIG. 5 shows an example of the clock frequency drifting (e.g., decreasing in the example of FIG. 5) by 50 percent during the specified time period. FIG. 5 shows that if the battery current is stable, a calculation of the average current value according to equation 1 may be accurate. However, when the battery current is variable, a calculation of the average current value according to equation 1 be not be accurate, such as due to the battery current during the period of higher frequency sampling being overweighted as compared to the battery current during the period of lower frequency sampling.

In an example, the estimated indication of the high-end inaccuracy can be determined by multiplying an estimated clock drift value by a current accumulation counter value, such as according to equation 4.

$$high-end\ inaccuracy = clock\ drift*accumulated\ current \qquad \text{Equation 4}$$

The estimated clock drift value can be a decimal representation of the absolute value of the clock drift (e.g., a 50 percent increase or decrease in clock frequency could be represented by an estimated clock drift value of 0.5). The clock drift can represent the highest recorded clock drift during the specified time period. By multiplying the clock drift value by the entire accumulated current during the specified time period, an estimated high-end inaccuracy can be determined.

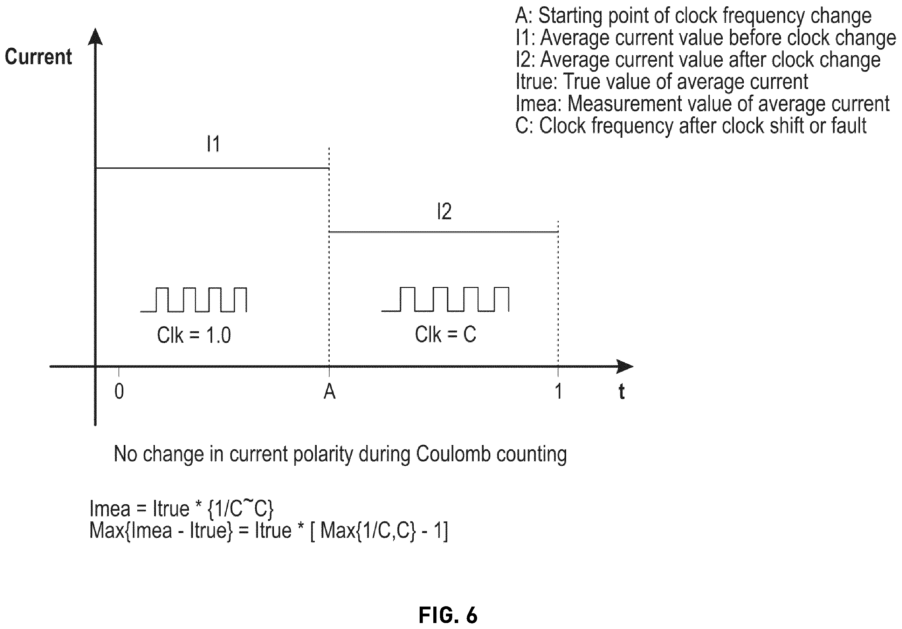

FIG. 6 shows a graph in time illustrating an example of operating portions of an AFE circuit 202. FIG. 6 shows that when the polarity (e.g., positive vs. negative, the direction of the current) of the battery current remains the same during the specified time period, equation 4 can provide an accurate determination of the estimated high-end inaccuracy.

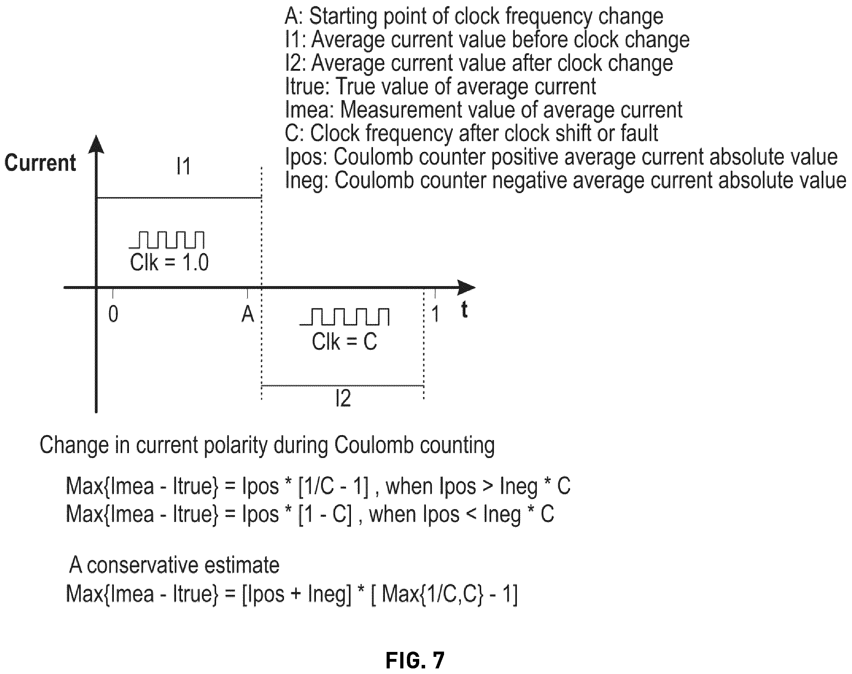

FIG. 7 shows a graph in time illustrating an example of operating portions of an AFE circuit. FIG. 7 shows that when the polarity of the battery current changes during the specified time period, using a single current accumulation counter that counts up for positive current and down for negative current may not necessarily provide an accurate estimated high-end inaccuracy value. Instead, it may be desirable to determine an absolute value of the accumulated current (e.g., using a current counter that counts up for positive values and counts up the absolute value of negative values, using a positive current counter that sums the positive values and a negative current counter that sums the negative values).

In an example, the first current measurement circuit 308 can include a positive current counter, which can be configured to accumulate a running total positive current value. The first current measurement circuit 308 can include a negative current counter, which can be configured to accumulate a running total negative current value. The estimated indication of high-end inaccuracy can be determined by multiplying the estimated clock drift value by a sum of (1) the running total positive current value and (2) the running total negative current value. In an example, the second current measurement circuit 310 can include a positive current counter and a negative current counter.

The estimated high-end inaccuracy can be transmitted to the host microcontroller 204. The host microcontroller 204 can use the estimated high-end inaccuracy in one or more ways. The host microcontroller 204 may use the estimated high-end inaccuracy to help to prevent a system fault. In an example where the energy storage device 106 is discharging and the host microcontroller 204 is working to prevent the energy storage device 106 from over-discharging, the estimated high-end inaccuracy may be added to the determined average current value before determining a charge current transfer value during the specified time period.

In an example, the battery management system 200 can include second current measurement circuitry (e.g., the second current measurement circuit 310, an additional current measurement circuit internal to or external to the AFE circuit 202) included in or coupled to the AFE circuit. The second current measurement circuitry can be configured to generate a second average current value, which can be representative of an average of the battery current for the specified time period. The battery management system 200 can also include current comparison circuitry, which can be configured to compare the average current value to the second average current value. The current comparison circuitry can be included in the AFE circuit 202. If the average current value and the second average current value differ by more than a specified amount, one or more of an alarm can be triggered, a worst-case-scenario one of the two can be used (e.g., using a higher average current value to determine SoC), or an average of the values can be used.

In an example, the AFE circuit 202 can include an input configured to receive a representation of a battery current associated with one or more cells in a battery system. The AFE circuit 202 can include current measurement circuitry, included in or coupled to the AFE circuit, the current measurement circuitry can be configured to generate an average current value representative of an average of the battery current for a specified time period. The AFE circuit 202 can include a second input which can be configured to receive a second representation of the battery current. The AFE circuit 202 can include second current measurement circuitry, which can be included in or coupled to the AFE circuit, the second current measurement circuitry can be configured to generate a second average current value representative of an average of the battery current for the specified time period. The AFE circuit 202 can include communication circuitry, which can be configured to transmit an indication of one or more of (1) the average current value, (2) the second average current value, or a (3) determined composite of the average current value and the second average current value (e.g., a central tendency, an average, a weighted average), to the host microcontroller 204. The host microcontroller 204 can be configured to determine a time value representative of a duration of the specified time period and determine, such as based on the received indication, a current transfer value of the battery current during the specified time period.

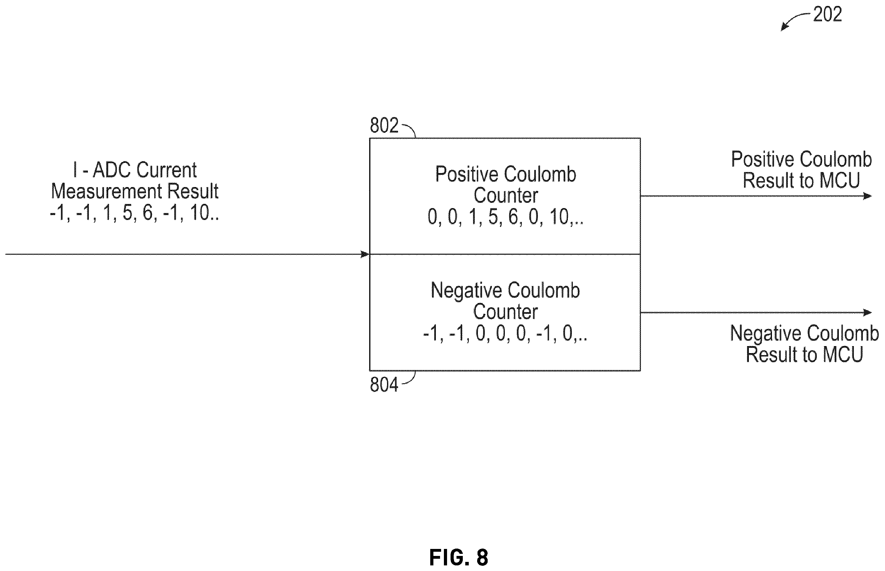

FIG. 8 shows a block diagram of an example of portions of an AFE circuit 202 and the operation thereof. FIG. 8 shows that the AFE circuit 202 can include a positive current counter 802 and a negative current counter 804. FIG. 8 shows that the received ADC current measurement results can be divided based on their polarity and summed in the respective current counters (e.g., the positive current counter 802 and the negative current counter 804). The value of the positive current counter 802 and the negative current counter 804 can be reported to the host microcontroller 204. **In** an example, a total current value can be reported to the host microcontroller 204, which can be obtained by adding the negative current counter 804 to the positive current counter 802.

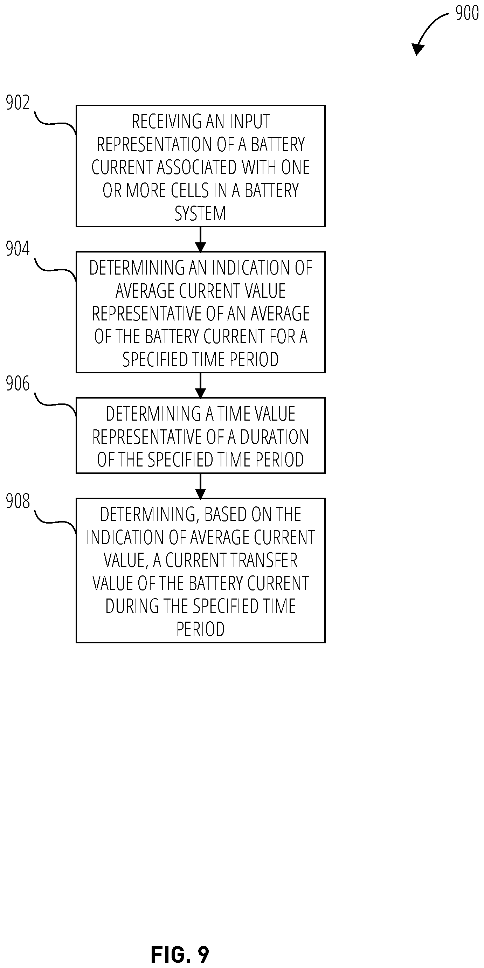

FIG. 9 shows an example of portions of a method 900 for operating a battery management system, such as the battery management system 200.

At step 902, an input representation of a battery current associated with one or more cells in a battery system can be received. For example, the AFE circuit 202 can receive a voltage input on the first positive current node 224 and the first negative current note 228 indicative of a current through the sense resistor 210.

At step 904, an indication of average current value representative of an average of the battery current for a specified time period can be determined. For example, the AFE circuit 202 can accumulate a running total current value (e.g., in the first current value register 320) and determine the average current value according to equation 1.

At step 906, a time value representative of a duration of the specified time period can be determined. For example, the host microcontroller 204 can determine the time value.

At step 908, a current transfer value of the battery current during the specified time period can be determined, such as based on the indication of average current value. For example, determining the current transfer value can include multiplying a representation of the time value by a representation of the indication of the average current value.

In an example, the method can include using a host microcontroller operated in accordance with a first clock signal to determine the time value and an AFE circuit operated in accordance with a second clock signal that is unsynchronized with the first clock signal to determine the average current value.

The shown order of steps is not intended to be a limitation on the order in which the steps are performed. In an example, two or more steps may be performed simultaneously or at least partially concurrently.

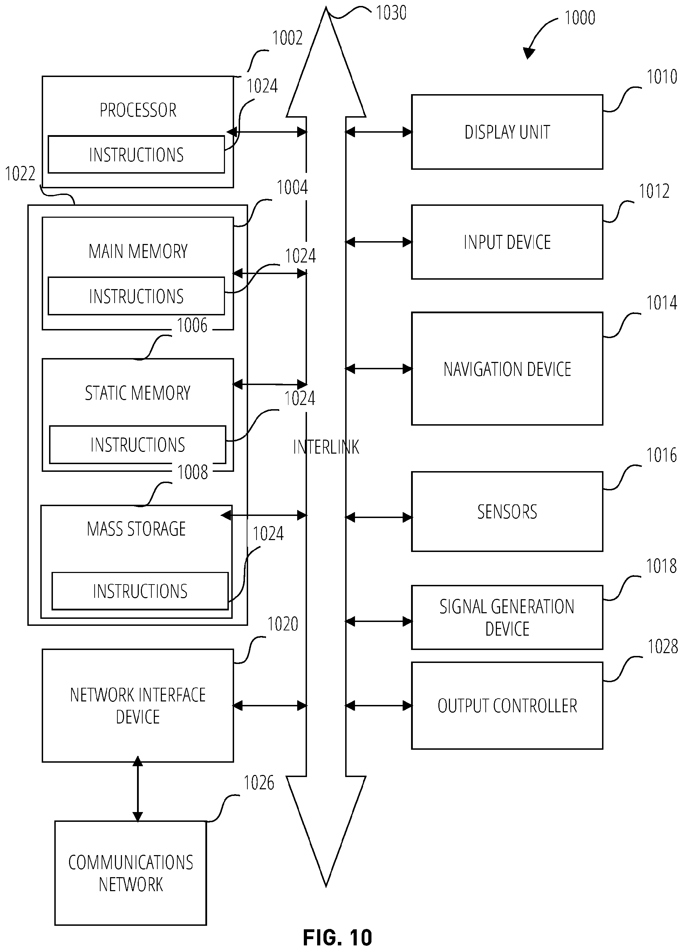

FIG. 10 illustrates a block diagram of an example machine 1000 upon which any one or more of the techniques (e.g., methodologies) discussed herein may be implemented. Examples, as described herein, may include, or may operate by, logic or a number of components, or mechanisms in the machine 1000. Circuitry (e.g., processing circuitry) is a collection of circuits implemented in tangible entities of the machine 1000 that include hardware (e.g., simple circuits, gates, logic, etc.). Circuitry membership may be flexible over time. Circuitries include members that may, alone or in combination, perform specified operations when operating. In an example, hardware of the circuitry may be immutably designed to carry out a specific operation (e.g., hardwired). In an example, the hardware of the circuitry may include variably connected physical components (e.g., execution units, transistors, simple circuits, etc.) including a machine readable medium physically modified (e.g., magnetically, electrically, moveable placement of invariant massed particles, etc.) to encode instructions of the specific operation. In connecting the physical components, the underlying electrical properties of a hardware constituent are changed, for example, from an insulator to a conductor or vice versa. The instructions enable embedded hardware (e.g., the execution units or a loading mechanism) to create members of the circuitry in hardware via the variable connections to carry out portions of the specific operation when in operation. Accordingly, in an example, the machine readable medium elements are part of the circuitry or are communicatively coupled to the other components of the circuitry when the device is operating. In an example, any of the physical components may be used in more than one member of more than one circuitry. For example, under operation, execution units may be used in a first circuit of a first circuitry at one point in time and reused by a second circuit in the first circuitry, or by a third circuit in a second circuitry at a different time. Additional examples of these components with respect to the machine 1000 follow.

In alternative examples, the machine 1000 may operate as a standalone device or may be connected (e.g., networked) to other machines. In a networked deployment, the machine 1000 may operate in the capacity of a server machine, a client machine, or both in server-client network environments. In an example, the machine 1000 may act as a peer machine in peer-to-peer (P2P) (or other distributed) network environment. The machine 1000 may be a personal computer (PC), a tablet PC, a set-top box (STB), a personal digital assistant (PDA), a mobile telephone, a web appliance, a network router, switch or bridge, or any machine capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations.

The machine 1000 may include a hardware processor 1002 (e.g., a central processing unit (CPU), a graphics processing unit (GPU), a hardware processor core, or any combination thereof), a main memory 1004, a static memory (e.g., memory or storage for firmware, microcode, a basic-input-output (BIOS), and mass storage 1008 (e.g., hard drives, tape drives, flash storage, or other block devices) some or all of which may communicate with each other via an interlink 1030 (e.g., bus). The machine 1000 may further include a display unit 1010, an alphanumeric input device 1012 (e.g., a keyboard), and a user interface (UI) navigation device 1014 (e.g., a mouse). In an example, the display unit 1010, input device 1012 and UI navigation device 1014 may be a touch screen display. The machine 1000 may additionally include a signal generation device 1018 (e.g., a speaker), a network interface device 1020, and one or more sensors 1016, such as a global positioning system (GPS) sensor, compass, accelerometer, or other sensor. The machine 1000 may include an output controller 1028, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.).

Registers of the processor 1002, the main memory 1004, the static memory 1006, or the mass storage 1008 may be, or include, a machine readable medium 1022 on which is stored one or more sets of data structures or instructions 1024 (e.g., software) embodying or utilized by any one or more of the techniques or functions described herein. The instructions 1024 may also reside, completely or at least partially, within any of registers of the processor 1002, the main memory 1004, the static memory 1006, or the mass storage 1008 during execution thereof by the machine 1000. In an example, one or any combination of the hardware processor 1002, the main memory 1004, the static memory 1006, or the mass storage 1008 may constitute the machine readable media 1022. While the machine readable medium 1022 is illustrated as a single medium, the term "machine readable medium" may include a single medium or multiple media (e.g., a centralized or distributed database, and/or associated caches and servers) configured to store the one or more instructions 1024.

The term "machine readable medium" may include any medium that is capable of storing, encoding, or carrying instructions for execution by the machine 1000 and that cause the machine 1000 to perform any one or more of the techniques of the present disclosure, or that is capable of storing, encoding or carrying data structures used by or associated with such instructions. Non-limiting machine readable medium examples may include solid-state memories, optical media, magnetic media, and signals (e.g., radio frequency signals, other photon based signals, sound signals, etc.). In an example, a non-transitory machine readable medium comprises a machine readable medium with a plurality of particles having invariant (e.g., rest) mass, and thus are compositions of matter. Accordingly, non-transitory machine-readable media are machine readable media that do not include transitory propagating signals. Specific examples of non-transitory machine readable media may include: non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; and CD-ROM and DVD-ROM disks.

In an example, information stored or otherwise provided on the machine readable medium 1022 may be representative of the instructions 1024, such as instructions 1024 themselves or a format from which the instructions 1024 may be derived. This format from which the instructions 1024 may be derived may include source code, encoded instructions (e.g., in compressed or encrypted form), packaged instructions (e.g., split into multiple packages), or the like. The information representative of the instructions 1024 in the machine readable medium 1022 may be processed by processing circuitry into the instructions to implement any of the operations discussed herein. For example, deriving the instructions 1024 from the information (e.g., processing by the processing circuitry) may include: compiling (e.g., from source code, object code, etc.), interpreting, loading, organizing (e.g., dynamically or statically linking), encoding, decoding, encrypting, unencrypting, packaging, unpackaging, or otherwise manipulating the information into the instructions 1024.

In an example, the derivation of the instructions 1024 may include assembly, compilation, or interpretation of the information (e.g., by the processing circuitry) to create the instructions 1024 from some intermediate or preprocessed format provided by the machine readable medium 1022. The information, when provided in multiple parts, may be combined, unpacked, and modified to create the instructions 1024. For example, the information may be in multiple compressed source code packages (or object code, or binary executable code, etc.) on one or several remote servers. The source code packages may be encrypted when in transit over a network and decrypted, uncompressed, assembled (e.g., linked) if necessary, and compiled or interpreted (e.g., into a library, stand-alone executable etc.) at a local machine, and executed by the local machine.

The instructions 1024 may be further transmitted or received over a communications network 1026 using a transmission medium via the network interface device 1020 utilizing any one of a number of transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), LoRa/LoRaWAN, or satellite communication networks, mobile telephone networks (e.g., cellular networks such as those complying with 3G, 4G LTE/LTE-A, or 5G standards), Plain Old Telephone (POTS) networks, and wireless data networks (e.g., Institute of Electrical and Electronics Engineers (IEEE) 802.11 family of standards known as Wi-Fi®, IEEE 802.15.4 family of standards, peer-to-peer (P2P) networks, among others. In an example, the network interface device 1020 may include one or more physical jacks (e.g., Ethernet, coaxial, or phone jacks) or one or more antennas to connect to the communications network 1026. In an example, the network interface device 1020 may include a plurality of antennas to wirelessly communicate using at least one of single-input multiple-output (SIMO), multiple-input multiple-output (MIMO), or multiple-input single-output (MISO) techniques. The term "transmission medium" shall be taken to include any intangible medium that is capable of storing, encoding or carrying instructions for execution by the machine 1000, and includes digital or analog communications signals or other intangible medium to facilitate communication of such software. A transmission medium is a machine-readable medium.

The following, non-limiting examples, detail certain aspects of the present subject matter to solve the challenges and provide the benefits discussed herein, among others.

Examples:

Example 1 is a battery management system comprising: a host microcontroller, operated in accordance with a first clock signal; and an analog front end (AFE) circuit, wherein the AFE circuit is operated in accordance with a second clock signal that is unsynchronized with the first clock signal, the AFE circuit comprising: an input configured to receive a representation of a battery current associated with one or more cells in a battery system; current measurement circuitry, included in or coupled to the AFE circuit, the current measurement circuitry configured to generate an average current value representative of an average of the battery current for a specified time period; and communication circuitry, configured to transmit an indication of the average current value to the host microcontroller; wherein the host microcontroller is configured to: determine a time value representative of a duration of the specified time period; and determine, based on the indication of the average current value, a current transfer value of the battery current during the specified time period.

In Example 2, the subject matter of Example 1 optionally includes wherein the host microcontroller is configured to: determine the current transfer value at least in part by multiplying a representation of the time value by a representation of the indication of the average current value.

In Example 3, the subject matter of any one or more of Examples 1-2 optionally include wherein: the AFE circuit determines the average current value in correspondence to a specified functional safety standard; and the host microcontroller determines the time value in correspondence to the specified functional safety standard.

In Example 4, the subject matter of Example 3 optionally includes wherein the host microcontroller determines the current transfer value in correspondence to the specified functional safety standard.

In Example 5, the subject matter of any one or more of Examples 3-4 optionally include wherein the AFE circuit is configured to operate in accordance with the second clock signal that is unsynchronized with the first clock signal, without requiring that the second clock signal meet a specified functional safety standard for time determination included in the specified functional safety standard.

In Example 6, the subject matter of any one or more of Examples 3-5 optionally include wherein the first clock signal is generated using a circuit that has at least one of a higher power consumption or a larger circuit area as compared to a circuit that generates the second clock signal.

In Example 7, the subject matter of any one or more of Examples 3-6 optionally include wherein to determine the time value in correspondence to the specified functional safety standard includes cross checking time values from at least two of the following: an oscillator internal to the host microcontroller, a redundant oscillator internal to the host microcontroller, an oscillator external to the host microcontroller, or an oscillator included in another circuit.

In Example 8, the subject matter of any one or more of Examples 1-7 optionally include wherein the current measurement circuitry includes at least two redundant current counters, including respective current inputs and respective accumulation counters.

In Example 9, the subject matter of any one or more of Examples 1-8 optionally include the AFE circuit comprising: a third clock signal input configured to receive a third clock signal, wherein the third clock signal operates at a different frequency than the second clock signal; and clock drift monitoring circuitry, configured to compare (1) a measured number of cycles of a higher frequency one of the second clock signal and the third clock signal during a specified number of cycles of a lower frequency one of the second clock signal and the third clock signal to (2) a reference number of cycles.

In Example 10, the subject matter of Example 9 optionally includes wherein the clock drift monitoring circuitry is configured to: determine the reference number of cycles by, at a beginning of the specified time period, measuring a number of cycles of a higher frequency one of the second clock signal and the third clock signal during a specified number of cycles of a lower frequency one of the second clock signal and the third clock signal; and, recurrently: determine the measured number of cycles; and compare the reference number of cycles to the measured number of cycles.

In Example 11, the subject matter of any one or more of Examples 9-10 optionally include wherein the clock drift monitoring circuitry is configured such that, in response to the measured number of cycles differing from the reference number of cycles by an amount greater than or equal to a threshold value, a clock drift is determined.

In Example 12, the subject matter of Example 11 optionally includes wherein in response to determining clock drift, an estimated indication of a high-end inaccuracy on the average current value is determined and transmitted to the host microcontroller.

In Example 13, the subject matter of Example 12 optionally includes wherein the estimated indication of the high-end inaccuracy is determined by multiplying an estimated clock drift value by a current accumulation counter value.

In Example 14, the subject matter of Example 13 optionally includes the AFE circuit comprising: a positive current counter, configured to accumulate a running total positive current value; and a negative current counter, configured to accumulate a running total negative current value, wherein the estimated indication of high-end inaccuracy is determined by multiplying the estimated clock drift value by a sum of the running total positive current value and the running total negative current value.

In Example 15, the subject matter of any one or more of Examples 1-14 optionally include wherein the AFE circuit comprises: second current measurement circuitry, included in or coupled to the AFE circuit, the second current measurement circuitry configured to generate a second average current value representative of an average of the battery current for the specified time period; and current comparison circuitry, configured to compare the average current value to the second average current value.

In Example 16, the subject matter of any one or more of Examples 1-15 optionally include wherein the AFE circuit is configured to: receive the representation of the battery current recurrently at a specified frequency, wherein the frequency is configurable by a user.

Example 17 is a method of operating a battery management system, the method comprising: receiving an input representation of a battery current associated with one or more cells in a battery system; determining an indication of average current value representative of an average of the battery current for a specified time period; determining a time value representative of a duration of the specified time period; and determining, based on the indication of average current value, a current transfer value of the battery current during the specified time period.

In Example 18, the subject matter of Example 17 optionally includes using a host microcontroller operated in accordance with a first clock signal to determine the time value and an AFE circuit operated in accordance with a second clock signal that is unsynchronized with the first clock signal to determine the average current value.

In Example 19, the subject matter of any one or more of Examples 17-18 optionally include wherein determining the current transfer value includes multiplying a representation of the time value by a representation of the indication of the average current value.

Example 20 is a battery management system comprising: a host microcontroller, operated in accordance with a first clock signal; and an analog front end (AFE) circuit, wherein the AFE circuit is operated in accordance with a second clock signal that is unsynchronized with the first clock signal, the AFE circuit comprising: an input configured to receive a representation of a battery current associated with one or more cells in a battery system; current measurement circuitry, included in or coupled to the AFE circuit, the current measurement circuitry configured to generate an average current value representative of an average of the battery current for a specified time period; a second input configured to receive a second representation of the battery current; and second current measurement circuitry, included in or coupled to the AFE circuit, the second current measurement circuitry configured to generate a second average current value representative of an average of the battery current for the specified time period; communication circuitry, configured to transmit an indication of at least one of (1) the average current value, (2) the second average current value, or (3) a determined composite of the average current value and the second average current value, to the host microcontroller; wherein the host microcontroller is configured to: determine a time value representative of a duration of the specified time period; and determine, based on the received indication, a current transfer value of the battery current during the specified time period.

Example 21 is at least one machine-readable medium including instructions that, when executed by processing circuitry, cause the processing circuitry to perform operations to implement of any of Examples 1-20.

Example 22 is an apparatus comprising means to implement of any of Examples 1-20.

Example 23 is a system to implement of any of Examples 1-20.

Example 24 is a method to implement of any of Examples 1-20.

Numbered Clause 1. A vehicle battery management system (BMS) capable of providing an Automotive Safety

Integrity Level C functional safety level, the system comprising:
a Coulomb counter to measure a battery state of charge (SoC) the Coulomb counter including:

a redundant real-time clock, configured to cross-check a BMS microcontroller clock with a Vehicle Control Unit (VCU) clock;
redundant current sampling circuitry, configured to use the redundant real-time clock to implement a clock drift detector to mitigate an impact of clock drift on current measurements performed by the redundant current sampling circuitry;
redundant coulomb accumulation circuitry, including separate and independent positive and negative current accumulators; and
redundant temperature sensors, configured to detect a clock change caused by a temperature change.

Numbered Clause 2. A method of using the system of Numbered Clause 1, including measuring SoC in the BMS including
one or more functional safety mechanisms as shown and described.

Numbered Clause 3. A device-readable medium including instructions that, when performed by the system, perform the method of Numbered Clause 2.

Numbered Clause 4. A system as shown and described herein.

Each of the non-limiting aspects above can stand on its own or can be combined in various permutations or combinations with one or more of the other aspects or other subject matter described in this document.

The above detailed description includes references to the accompanying drawings, which form a part of the detailed description. The drawings show, by way of illustration, specific examples that may be practiced. These embodiments are also referred to herein as "examples." Such examples may include elements in addition to those shown or described. However, the present inventors also contemplate examples in which only those elements shown or described are provided. Moreover, the present inventors also contemplate examples using any combination or permutation of those elements shown or described (or one or more aspects thereof), either with respect to a particular example (or one or more aspects thereof), or with respect to other examples (or one or more aspects thereof) shown or described herein.

All publications, patents, and patent documents referred to in this document are incorporated by reference herein in their entirety, as though individually incorporated by reference. In the event of inconsistent usages between this document and those documents so incorporated by reference, the usage in the incorporated reference(s) should be considered supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the terms "or" and "and/or" are used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

The term "about," as used herein, means approximately, in the region of, roughly, or around. When the term "about" is used in conjunction with a numerical range, it modifies that range by extending the boundaries above and below the numerical values set forth. In general, the term "about" is used herein to modify a numerical value above and below the stated value by a variance of 10%. In one aspect, the term "about" means plus or minus 10% of the numerical value of the number with which it is being used. Therefore, about 50% means in the range of 45%-55%. Numerical ranges recited herein by endpoints include all numbers and fractions subsumed within that range (e.g., 1 to 5 includes 1, 1.5, 2, 2.75, 3, 3.90, 4, 4.24, and 5). Similarly, numerical ranges recited herein by endpoints include subranges subsumed within that range (e.g., 1 to 5 includes 1-1.5, 1.5-2, 2-2.75, 2.75-3, 3-3.90, 3.90-4, 4-4.24, 4.24-5, 2-5, 3-5, 1-4, and 2-4).

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Such instructions can be read and executed by one or more processors to enable performance of operations comprising a method, for example. The instructions are in any suitable form, such as but not limited to source code, compiled code, interpreted code, executable code, static code, dynamic code, and the like.

Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

The above description is intended to be illustrative, and not restrictive. For example, the above-described examples (or one or more aspects thereof) may be used in combination with each other. Other examples may be used, such as by one of ordinary skill in the art upon reviewing the above description. The Abstract is to allow the reader to quickly ascertain the nature of the technical disclosure and is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description, with each claim standing on its own as a separate embodiment. The scope of the examples should be determined with reference to the appended claims, along with the full scope of equivalents to which such claims are entitled.

**Claims**

1. A battery management system comprising:

   a host microcontroller, operated in accordance with a first clock signal; and
   an analog front end (AFE) circuit, wherein the AFE circuit is operated in accordance with a second clock signal that is unsynchronized with the first clock signal, the AFE circuit comprising:

   an input configured to receive a representation of a battery current associated with one or more cells in a battery system;
   current measurement circuitry, included in or coupled to the AFE circuit, the current measurement circuitry configured to generate an average current value representative of an average of the battery current for a specified time period; and
   communication circuitry, configured to transmit an indication of the average current value to the host microcontroller;

   wherein the host microcontroller is configured to:

determine a time value representative of a duration of the specified time period; and
determine, based on the indication of the average current value, a current transfer value of the battery current during the specified time period.

2. The battery management system of claim 1, wherein the host microcontroller is configured to:
determine the current transfer value at least in part by multiplying a representation of the time value by a representation of the indication of the average current value.

3. The battery management system of claim 1 or 2, wherein:

the AFE circuit determines the average current value in correspondence to a specified functional safety standard; and
the host microcontroller determines the time value in correspondence to the specified functional safety standard.

4. The battery management system of claim 3, wherein the host microcontroller determines the current transfer value in correspondence to the specified functional safety standard.

5. The battery management system of claim 3 or 4, wherein the AFE circuit is configured to operate in accordance with the second clock signal that is unsynchronized with the first clock signal, without requiring that the second clock signal meet a specified functional safety standard for time determination included in the specified functional safety standard.

6. The battery management system of any of claims 3 to 5, wherein the first clock signal is generated using a circuit that has at least one of a higher power consumption or a larger circuit area as compared to a circuit that generates the second clock signal.

7. The battery management system of any of claims 3 to 6, wherein to determine the time value in correspondence to the specified functional safety standard includes cross checking time values from at least two of the following: an oscillator internal to the host microcontroller, a redundant oscillator internal to the host microcontroller, an oscillator external to the host microcontroller, or an oscillator included in another circuit.

8. The battery management system of any preceding claim, wherein the current measurement circuitry includes at least two redundant current counters, including respective current inputs and respective accumulation counters.

9. The battery management system of any preceding claim, the AFE circuit comprising:

a third clock signal input configured to receive a third clock signal, wherein the third clock signal operates at a different frequency than the second clock signal; and
clock drift monitoring circuitry, configured to compare (1) a measured number of cycles of a higher frequency one of the second clock signal and the third clock signal during a specified number of cycles of a lower frequency one of the second clock signal and the third clock signal to (2) a reference number of cycles,
preferably wherein the clock drift monitoring circuitry is configured to: determine the reference number of cycles by, at a beginning of the specified time period, measuring a number of cycles of a higher frequency one of the second clock signal and the third clock signal during a specified number of cycles of a lower frequency one of the second clock signal and the third clock signal; and, recurrently:

determine the measured number of cycles; and
compare the reference number of cycles to the measured number of cycles.

10. The battery management system of claim 9, wherein the clock drift monitoring circuitry is configured such that, in response to the measured number of cycles differing from the reference number of cycles by an amount greater than or equal to a threshold value, a clock drift is determined,

preferably wherein in response to determining clock drift, an estimated indication of a high-end inaccuracy on the average current value is determined and transmitted to the host microcontroller,
more preferably wherein the estimated indication of the high-end inaccuracy is determined by multiplying an estimated clock drift value by a current accumulation counter value,
yet more preferably wherein the AFE circuit further comprises:

a positive current counter, configured to accumulate a running total positive current value; and

a negative current counter, configured to accumulate a running total negative current value, wherein the estimated indication of high-end inaccuracy is determined by multiplying the estimated clock drift value by a sum of the running total positive current value and the running total negative current value.

11. The battery management system of any preceding claim, wherein the AFE circuit further comprises a second input configured to receive a second representation of the battery current.

12. The battery management system of any preceding claim, wherein the AFE circuit comprises:

second current measurement circuitry, included in or coupled to the AFE circuit, the second current measurement circuitry configured to generate a second average current value representative of an average of the battery current for the specified time period; and

current comparison circuitry, configured to compare the average current value to the second average current value,

preferably wherein the communication circuitry is further configured to transmit an indication of at least one of (1) the second average current value, and (2) a determined composite of the average current value and the second average current value, to the host microcontroller.

13. The battery management system of any preceding claim, wherein the AFE circuit is configured to:
receive the representation of the battery current recurrently at a specified frequency, wherein the frequency is configurable by a user.

14. A method of operating a battery management system, the method comprising:

receiving an input representation of a battery current associated with one or more cells in a battery system;

determining an indication of average current value representative of an average of the battery current for a specified time period;

determining a time value representative of a duration of the specified time period; and

determining, based on the indication of average current value, a current transfer value of the battery current during the specified time period.

15. The method of claim 14, further comprising:

using a host microcontroller operated in accordance with a first clock signal to determine the time value and an AFE circuit operated in accordance with a second clock signal that is unsynchronized with the first clock signal to determine the average current value

and/or

wherein determining the current transfer value includes multiplying a representation of the time value by a representation of the indication of the average current value.

FIG. 1

FIG. 2

**FIG. 3**

402

8KHz, 1KHz
,etc.

404

3.2MHz

406 ⌇ CNTx

t

**FIG. 4A**

408

410

412

414 CNT1

416 CNT2

CNTx

418 CNTN

HB1

HB2

HBx

HBN

t

**FIG. 4B**

**FIG. 5**

A: Starting point of clock frequency change
I1: Average current value before clock change
I2: Average current value after clock change
Itrue: True value of average current
Imea: Measurement value of average current
C: Clock frequency after clock shift or fault

Current

I1    I2

Clk = 1.0    Clk = C

0    A    1    t

No change in current polarity during Coulomb counting

$Imea = Itrue * \{1/C \sim C\}$
$Max\{Imea - Itrue\} = Itrue * [Max\{1/C,C\} - 1]$

**FIG. 6**

EP 4 632 402 A1

A: Starting point of clock frequency change
I1: Average current value before clock change
I2: Average current value after clock change
Itrue: True value of average current
Imea: Measurement value of average current
C: Clock frequency after clock shift or fault
Ipos: Coulomb counter positive average current absolute value
Ineg: Coulomb counter negative average current absolute value

**Current**

I1

Clk = 1.0

0    A    1   t

Clk = C

I2

Change in current polarity during Coulomb counting

$Max\{Imea - Itrue\} = Ipos * [1/C - 1]$ , when $Ipos > Ineg * C$
$Max\{Imea - Itrue\} = Ipos * [1 - C]$ , when $Ipos < Ineg * C$

A conservative estimate
$Max\{Imea - Itrue\} = [Ipos + Ineg] * [ Max\{1/C,C\} - 1]$

**FIG. 7**

EP 4 632 402 A1

202

802

I - ADC Current
Measurement Result
-1, -1, 1, 5, 6, -1, 10..

Positive Coulomb
Counter
0, 0, 1, 5, 6, 0, 10,..

Positive Coulomb
Result to MCU

Negative Coulomb
Counter
-1, -1, 0, 0, 0, -1, 0,..

Negative Coulomb
Result to MCU

804

**FIG. 8**

900

902

RECEIVING AN INPUT REPRESENTATION OF A BATTERY CURRENT ASSOCIATED WITH ONE OR MORE CELLS IN A BATTERY SYSTEM

904

DETERMINING AN INDICATION OF AVERAGE CURRENT VALUE REPRESENTATIVE OF AN AVERAGE OF THE BATTERY CURRENT FOR A SPECIFIED TIME PERIOD

906

DETERMINING A TIME VALUE REPRESENTATIVE OF A DURATION OF THE SPECIFIED TIME PERIOD

908

DETERMINING, BASED ON THE INDICATION OF AVERAGE CURRENT VALUE, A CURRENT TRANSFER VALUE OF THE BATTERY CURRENT DURING THE SPECIFIED TIME PERIOD

**FIG. 9**

**FIG. 10**

Europäisches
Patentamt
European
Patent Office
Office européen
des brevets

# EUROPEAN SEARCH REPORT

**Application Number**

EP 25 16 9720

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/184842 A1 (LIN YIJING [CN] ET AL) 15 June 2023 (2023-06-15) | 1-8, 11-15 | INV.<br>G01R31/3832 |
| A | * paragraphs [0004] - [0011], [0021] - [0053], [0061]; figures 1-3, 7 * | 9,10 | |
| A | US 2023/123869 A1 (MARTINEZ VINCENT PIERRE [FR] ET AL) 20 April 2023 (2023-04-20)<br>* paragraphs [0002] - [0004], [0016] - [0025]; figures 1-2 * | 1-15 | |
| A | US 2020/028219 A1 (LEE JAESIK [US] ET AL) 23 January 2020 (2020-01-23)<br>* lines 22-40; figures 1-4 * | 1-15 | |
| A | US 2023/184847 A1 (LIN YIJING [CN] ET AL) 15 June 2023 (2023-06-15)<br>* paragraphs [0018] - [0040], [0005] - [0011]; figures 1-3 * | 1-15 | |

**TECHNICAL FIELDS SEARCHED (IPC)**

G01R

The present search report has been drawn up for all claims

| Place of search | Date of completion of the search | Examiner |
|---|---|---|
| Munich | 19 August 2025 | Maric, Viktor |

EPO FORM 1503 03.82 (P04C01)

## ANNEX TO THE EUROPEAN SEARCH REPORT
## ON EUROPEAN PATENT APPLICATION NO.

EP 25 16 9720

This annex lists the patent family members relating to the patent documents cited in the above-mentioned European search report.
The members are as contained in the European Patent Office EDP file on
The European Patent Office is in no way liable for these particulars which are merely given for the purpose of information.

19-08-2025

| Patent document cited in search report | Publication date | Patent family member(s) | Publication date |
|---|---|---|---|
| US 2023184842 A1 | 15-06-2023 | NONE | |
| US 2023123869 A1 | 20-04-2023 | EP 4166958 A1 | 19-04-2023 |
| | | US 2023123869 A1 | 20-04-2023 |
| US 2020028219 A1 | 23-01-2020 | CN 110736931 A | 31-01-2020 |
| | | US 2020028219 A1 | 23-01-2020 |
| US 2023184847 A1 | 15-06-2023 | US 2023184847 A1 | 15-06-2023 |
| | | US 2025116724 A1 | 10-04-2025 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2024087071 W, Shi

- US 17408125